(19) Europäisches Patentamt

European Patent Office

Office européen des brevets

(11) **EP 0 853 384 A1**

## (12) DEMANDE DE BREVET EUROPEEN

(43) Date de publication:
**15.07.1998 Bulletin 1998/29**

(51) Int. Cl.⁶: **H03K 3/00**, H03K 3/03

(21) Numéro de dépôt: **97100261.3**

(22) Date de dépôt: **09.01.1997**

(84) Etats contractants désignés:
**DE FR GB NL**

(71) Demandeur: **ASULAB S.A.**
**CH-2501 Bienne (CH)**

(72) Inventeurs:
• **Wattenhofer, Jean-Pierre**
**2000 Neuchâtel (CH)**

• **Farine, Pierre-André**
**2003 Neuchâtel (CH)**

(74) Mandataire:
**Thérond, Gérard Raymond et al**
**I C B**
**Ingénieurs Conseils en Brevets SA**
**Rue des Sors 7**
**2074 Marin (CH)**

### (54) Oscillateur fonctionnant avec une faible tension d'alimentation

(57) Cet oscillateur est réalisé en technologie CMOS et comprend des moyens (L1, L2) pour polariser dans le sens direct la jonction source-caisson (S-B) d'au moins certains de ses transistors (M2, M4, M6), et des moyens (R1, R3) pour limiter le courant circulant à travers cette jonction (S-B).

Ce montage a pour effet d'abaisser le seuil des transistors, en particulier ceux du même type que le substrat.

Application notamment aux pièces d'horlogerie électroniques destinées à être alimentées au moyen d'une unique cellule photovoltaïque.

Fig. 10

EP 0 853 384 A1

## Description

La présente invention est relative à un oscillateur fonctionnant avec une très faible tension d'alimentation.

Plus précisément, l'invention concerne un oscillateur réalisé en technologie CMOS et pouvant être alimenté avec une tension provenant d'une source d'énergie dont la tension ne dépasse pas 0,4 à 0,5 V.

Une telle source d'énergie peut être formée par exemple par une cellule photovoltaïque dont, dans certains cas, on souhaite n'en utiliser qu'une seule dans un même appareil. C'est le cas par exemple de certaines pièces d'horlogerie, comme les montres solaires, qui pour des raisons de prix de revient et d'esthétique, ont avantage à n'être équipées que d'une seule source photovoltaïque.

Cependant, dans une telle application, la tension d'alimentation des composants du circuit intégré assurant les fonctions de l'appareil, doit être d'au moins 1 V de sorte que l'on doit utiliser un élévateur de tension pour convertir la tension d'environ 0,4 V de la source photovoltaïque en une tension se situant typiquement à environ 1,2 à 1,3 V. Un tel élévateur de tension comprend avantageusement une self qui est commutée alternativement en court-circuit et sur un accumulateur à grande capacité, la commutation étant pilotée par un oscillateur. Celui-ci doit ainsi pouvoir travailler, ne serait-ce que pour démarrer l'appareil lorsqu'il a séjourné longtemps dans l'obscurité, à une tension d'alimentation qui ne peut être supérieure à celle de l'unique source photovoltaïque.

Pour plus de détails concernant un tel élévateur de tension et son circuit de commande associé, on se référera à la demande de brevet déposée ce même cour au nom de la Demanderesse et ayant pour titre "Appareil électrique fonctionnant à l'aide d'une source photovoltaïque, notamment pièce d'horlogerie". Il doit être noté toutefois que la présente invention n'est pas limitée à l'application brièvement énoncée ci-dessus, mais qu'elle peut, au contraire, trouver son application dans tous les cas où, dans un appareil réalisé en technologie CMOS, on doit utiliser un oscillateur, alors que la tension d'alimentation disponible est inférieure à la tension de seuil des transistors MOS utilisés pour le circuit intégré de cet appareil.

L'invention a ainsi pour but de proposer un oscillateur en technologie CMOS fonctionnant avec une très faible tension d'alimentation.

Elle a donc pour objet un oscillateur réalisé en technologie CMOS et fonctionnant avec une faible tension d'alimentation caractérisé en ce qu'il comprend

- des moyens pour polariser dans le sens direct la jonction source-caisson d'au moins certains de ses transistors, et
- des moyens pour limiter le courant circulant à travers cette jonction.

Grâce à ces caractéristiques, au moins certains des transistors composant l'oscillateur peuvent fonctionner avec une tension de seuil réduite ce qui permet d'abaisser leur tension d'alimentation.

D'autres caractéristiques et avantages de l'invention apparaîtront au cours de la description qui va suivre, donnée uniquement à titre d'exemple et faite en se référant aux dessins annexés sur lesquels:

- la figure 1 est une vue en coupe schématique d'un transistor à canal N dans la technologie à substrat de type N et à caisson de type P;
- les figures 2 et 3 montrent deux schémas de polarisation de caisson pour le transistor représenté sur la figure 1;
- la figure 4 est une vue en coupe de deux transistors, respectivement à canal P et à canal N dans la technologie à substrat de type P et à caisson de type N;
- les figures 5 à 9 montrent d'autres montages possibles pour assurer la polarisation de caisson;
- la figure 10 est un schéma d'un oscillateur réalisé selon le concept de l'invention; et
- la figure 11 montre plusieurs diagrammes des signaux apparaissant dans l'oscillateur représenté sur la figure 10.

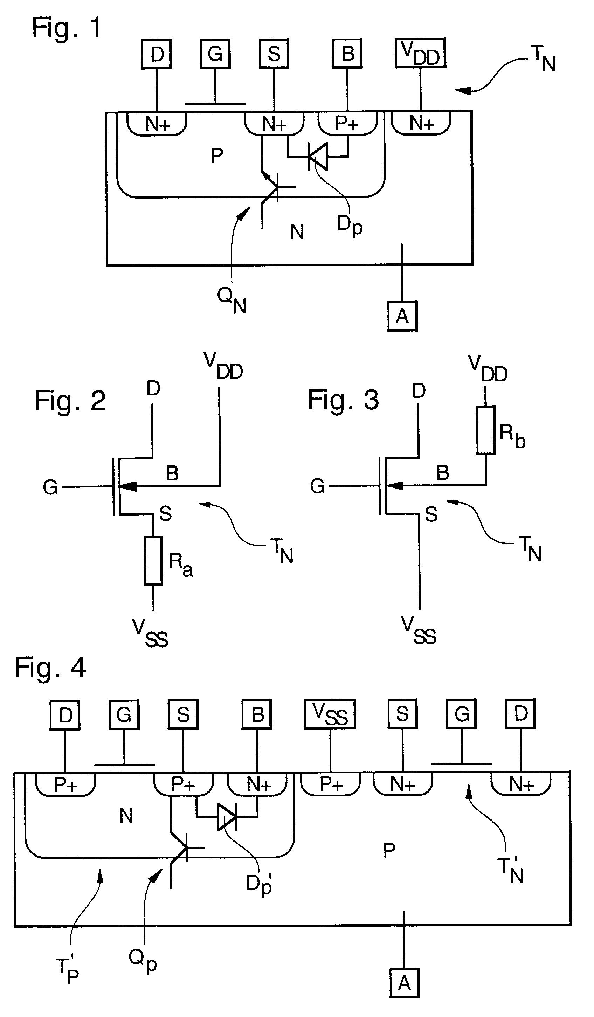

La figure 1 représente en coupe un transistor MOS à canal N dans une technologie à substrat N et à caisson P, la notation suivante étant utilisée: A-substrat, B-caisson, D-drain, G-grille, S-source, $V_{DD}$-connexion d'alimentation positive. La théorie d'un tel transistor CMOS démontre que si l'on veut le faire fonctionner avec un seuil de commutation très faible, il convient de le faire travailler dans le domaine de faible inversion. Ceci peut être obtenu en particulier en déterminant convenablement le dimensionnement du transistor et notamment sa largeur (notée W par les spécialistes). L'accroissement de ce paramètre W va de pair avec une augmentation du courant de drain $I_D$ selon la formule bien connue:

$$I_D = (I_O*W/L)*exp(V_G/nU_T)*(exp(-V_S/U_T)-exp(V_D/U_T))$$

dans laquelle:

W - largeur du transistor

L - longueur du transistor

$V_G$ - tension de grille

$V_S$ - tension de source

$V_D$ - tension de drain

$U_T$ - tension thermodynamique

La formule donnée ci-dessus montre que le courant $I_D$ peut être augmenté non seulement en augmentant le paramètre W, mais également en agissant sur la tension $V_S$, les tensions $V_G$ et $V_D$ étant par ailleurs déterminées par la tension d'alimentation $V_{DD}$-$V_{SS}$ disponible.

La figure 1 montre également que le transistor à canal N en technologie à substrat de type N et à caisson de type P, présente des éléments parasites que l'on peut symboliser par une diode $D_P$ connectée entre la source S et le caisson B et par un transistor bipolaire $Q_N$ dont le collecteur est formé par le substrat A, l'émetteur par la source S et la base par le caisson B. Ces éléments parasites conduisent les concepteurs des circuits intégrés CMOS à maintenir la tension $V_S$ à une valeur positive ou nulle afin d'éviter que les courants dans ces éléments parasites soient trop élevés.

La présente invention est basée sur le concept que l'on peut polariser dans une certaine mesure la jonction entre la source S et le caisson B (c'est-à-dire la diode $D_P$) en appliquant au caisson B un potentiel plus élevé que celui de la source S et en prévoyant en même temps des moyens limitant le courant dans la jonction entre la source S et le caisson B à une certaine valeur.

Un montage de principe mettant en oeuvre ce concept apparaît sur la figure 2. Il s'agit du transistor $T_N$ représenté sur la figure 1 dont le caisson B est relié au potentiel $V_{DD}$ et dont la source S est connectée à la tension $V_{SS}$ par l'intermédiaire d'un moyen de limitation de courant qui est dans ce cas une résistance $R_a$. La figure 3 montre une variante de ce montage dans laquelle les moyens de limitation de courant sont constitués par une résistance $R_b$ reliée entre le caisson B et le potentiel $V_{DD}$.

Dans la technologie CMOS à substrat de type N et à caisson de type P, le caisson d'un transistor à canal de type P est en fait le substrat, comme le substrat A de la figure 1. Celui-ci est commun à tout le circuit et il est relié au potentiel le plus positif ($V_{DD}$). Dans ces conditions, il n'est pas possible de polariser la source à un potentiel supérieur à celle du substrat. Ceci n'est pas un inconvénient majeur, car dans cette technologie, les tensions de seuil des transistors de type P sont en général plus faibles que celles des transistors de type N, de sorte qu'il n'est pas nécessaire de prévoir des mesures particulières en ce qui concerne les transistors de type P dans ce cas, si la tension d'alimentation est faible.

La figure 4 montre en coupe et côte à côte deux transistors dans la technologie CMOS à substrat de type P et à caisson de type N avec un transistor $T_P'$ de type P et un transistor $T_N'$ de type N. Les considérations évoquées ci-dessus à propos du cas complémentaire, sont ici également applicables à condition d'intervertir les polarités des tensions. En outre, dans ce cas le dimensionnement des transistors n'est pas identique en raison de la dissymétrie de la mobilité des porteurs de charge qui est plus grande pour les transistors à canal N que pour les transistors à canal P.

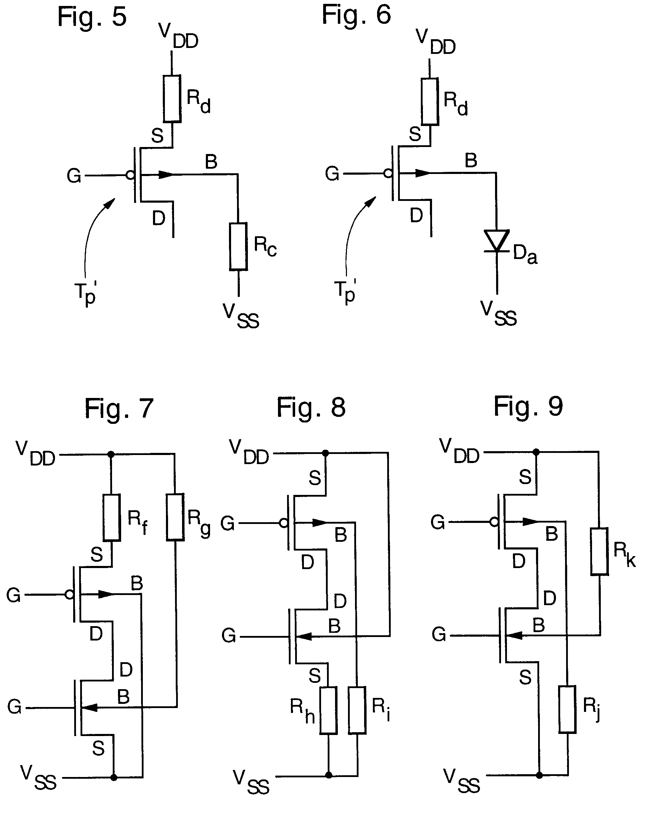

Ainsi, sur la figure 5, on a représenté le cas du transistor $T_P'$ conformément à la figure 4, son caisson B étant connecté au potentiel $V_{SS}$ par l'intermédiaire d'une résistance $R_c$ formant dans ce cas une première partie des moyens de limitation de courant et raccordée entre le caisson B et le potentiel $V_{SS}$. La deuxième partie de ces moyens peut être formée par une autre résistance $R_d$ raccordée entre le potentiel $V_{DD}$ et la source de ce transistor $T_P'$ de type P.

La figure 6 montre une variante du montage de la figure 5, dans laquelle la résistance $R_c$ est remplacée par une diode $D_a$ branchée dans le sens passant entre le caisson B et le potentiel $V_{SS}$.

On peut également envisager d'appliquer le concept de l'invention à la technologie dite "twin-well" selon laquelle on peut loger chacun des deux types de transistors dans des caissons individuels sur un seul et même substrat. On peut alors polariser les deux types de caissons selon les schémas qui sont représentés respectivement sur les figures 7, 8 et 9 montrant diverses possibilités d'implantation des moyens de limitation de courant vis-à-vis des transistors, ces moyens étant respectivement formés par des résistances $R_f$ et $R_g$, $R_h$ et $R_i$, et $R_j$ et $R_k$.

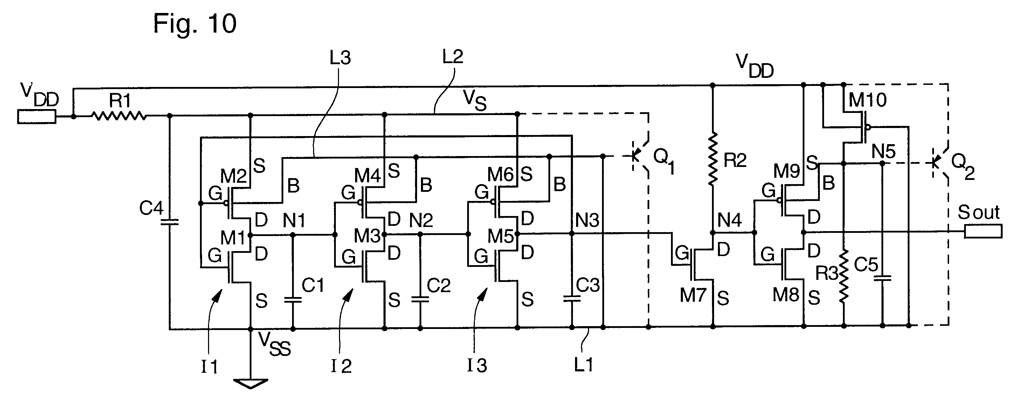

La figure 10 représente un exemple de réalisation d'un oscillateur conçu sur la base du concept ci-dessus, le schéma adopté pour abaisser la tension de seuil étant celui de la figure 5 en omettant toutefois la résistance $R_c$ et la configuration de la structure des transistors utilisés étant celle de la figure 4.

La conception choisie pour cet oscillateur est le schéma d'un oscillateur en anneau comprenant trois inverseurs I1, I2 et I3 en cascade, chaque inverseur étant réalisé à partir de l'association de deux transistors complémentaires référencés M1-M2, M3-M4 et M5-M6, respectivement. Dans chaque inverseur, les trajets source-drain des transistors sont reliés en série entre eux entre une ligne de tension L1 à laquelle est appliquée la tension $V_{SS}$ et une ligne de tension L2 référencée comme tension $V_S$.

Les grilles des transistors M1 et M2 sont connectées par une connexion de rebouclage en anneau à un noeud N3 qui est la connexion de drain commune des transistors M5 et M6. La connexion de drain commune des transistors M1 et M2 forme un noeud N1 qui est relié aux grilles des transistors M3 et M4. La connexion de drain commune des transistors M3 et M4 forme un noeud N2 qui est relié aux grilles des transistors M5 et M6.

Les noeuds N1, N2 et N3 sont reliés en outre à la ligne L1 par l'intermédiaire de condensateurs respectifs C1, C2 et C3.

Les caissons B des transistors de type P de ce montage soit reliés en commun à une ligne L3 qui est connectée à la ligne L1. Par ailleurs, la ligne L2 est connectée à la borne de tension $V_{DD}$ par l'intermédiaire d'une résistance R1 qui, au sens de la présente invention, joue le rôle des moyens de limitation de courant à la fois pour les trois transistors de type P, M2, M4 et M6 du montage. Un condensateur C4 de stabilisation de tension relie entre elles les lignes L1 et L2.

La combinaison de la résistance R1 et du condensateur C4 réduit quelque peu l'amplitude à la sortie de l'oscillateur proprement dit (noeud N3). Dans certains cas, et notamment dans l'application décrite en préambule à la présente description où l'oscillateur doit commander un élévateur de tension, il peut être souhaitable d'adjoindre au montage d'une part un circuit de décalage de niveau formé ici par un transistor M7 à canal N et une résistance R2 et d'autre part, un circuit d'attaque formé de transistors M8 et M9 respectivement à canal N et à canal P.

La grille du transistor M7 est connecté au noeud N3, tandis que son trajet source-drain est relié en série avec la résistance R2 entre la borne $V_{DD}$ et la ligne L1, leur point commun formant un noeud N4.

Les transistors M8 et M9 du circuit d'attaque ont leurs grilles reliées entre elles et au noeud N4. Leurs trajets source-drain sont connectés en série entre la borne $V_{DD}$ et la ligne L1. Les drains des transistors M8 et M9 constituent la sortie $S_{out}$ du montage. Par ailleurs, on notera que le caisson du transistor M9 est connecté à la ligne L1 par l'intermédiaire d'une résistance R3 montée en parallèle à un condensateur C5. Ce montage polarise la jonction caisson-source du transistor M9 en vue d'abaisser sa tension de seuil comme pour les transistors M2, M4 et M6.

On remarquera également que sur le schéma de la figure 10, on a représenté les transistors parasites Q1 et Q2 qui correspondent au transistor $Q_P$ représenté sur la coupe de la figure 4. Le transistor Q1 n'est pas gênant, car il agit comme une diode en parallèle aux jonctions caisson-source des transistors M2, M4 et M6.

Pour ce qui est du transistor Q2, il constitue un chemin de conduction direct entre la ligne L1 et la borne $V_{DD}$. Il est donc recommandé de prévoir un transistor M10 de type P supplémentaire tout au moins si la tension $V_{DD}$-$V_{SS}$ risque de monter au delà de 0,6V dans certaines circonstances. En effet, à basse tension d'alimentation, inférieure à O,5 V, le courant dans ce transistor Q2 n'est pas très important. En revanche, pour des tensions plus élevées, ce courant augmente fortement.

Le trajet source-drain du transistor M10 est connecté en série avec une résistance R3 entre la borne $V_{DD}$ et la ligne L1 à laquelle est aussi connectée sa grille. Le noeud N5 entre le drain de ce transistor M10 et la résistance R3 est relié au caisson B du transistor M9. Le caisson B du transistor M10 est par contre connecté à la borne $V_{DD}$. Ainsi, dès que la tension $V_{DD}$ dépasse le seuil de conduction du transistor M10, il relie le caisson du transistor M9 à la borne $V_{DD}$ supprimant ainsi la conduction par le transistor Q2.

Une variante du schéma que l'on vient de décrire consiste à relier les moyens de limitation de courant des transistors M2, M4 et M6 entre leurs caissons B et la ligne L1, comme cela a été fait pour le transistor M9. Dans ce cas, on peut éventuellement se dispenser d'utiliser le transistor M7 de décalage de niveau. Cependant, une telle variante ne serait guère utilisable si la tension d'alimentation risque de varier entre 0,4 et 0,6 V, car dans ce cas, la fréquence de l'oscillateur pourrait varier très fortement (typiquement d'un facteur 75), alors que dans le montage représenté sur la figure 10, cette variation de fréquence ne serait que d'un facteur 4 pour une même variation de la tension d'alimentation.

Bien entendu, les solutions illustrées sur les figures 6 à 9 peuvent également être utilisées pour la réalisation de l'oscillateur.

Il est à signaler que celle de la figure 6 est avantageuse en ce sens qu'elle permet d'obtenir un accroissement de 15% à 20% de l'amplitude du signal de sortie par rapport à celle du signal que l'on obtient sur le noeud N3 de la figure 10.

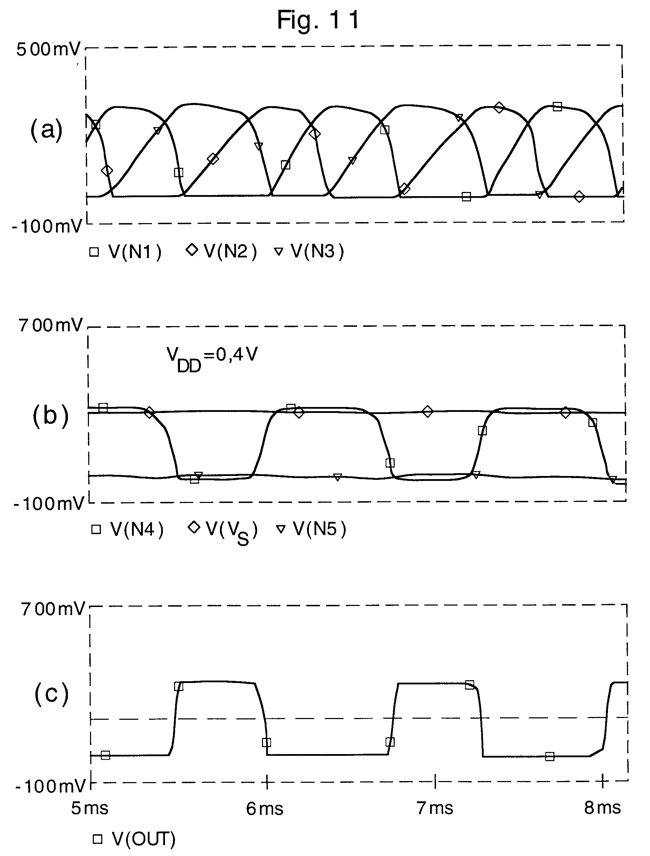

La figure 11 représente en fonction du temps plusieurs formes d'onde a, b, et c des signaux obtenus en divers points du circuit de la figure 10.

**Revendications**

1. Oscillateur réalisé en technologie CMOS et fonctionnant avec une faible tension d'alimentation caractérisé en ce qu'il comprend

   des moyens (L1, L2) pour polariser dans le sens direct la jonction source-caisson (S-B) d'au moins certains de ses transistors (M2, M4, M6), et
   des moyens (R1, R3; $R_a$ à $R_k$, $D_a$) pour limiter le courant circulant à travers cette jonction (S-B).

2. Oscillateur suivant la revendication 1, caractérisé en ce que lesdits moyens de limitation de courant (R1, R3; $R_a$ à $R_k$, $D_a$) comprennent au moins une résistance montée en série avec lesdits moyens de polarisation entre les bornes d'alimentation ($V_{DD}$, $V_{SS}$) de l'oscillateur.

**3.** Oscillateur suivant la revendication 2, caractérisé en ce qu'une seule résistance ($R_a$, $R_c$, $R_f$, $R_h$, R1) est connectée à la source (S) du transistor ($T_N$, $T_P$').

**4.** Oscillateur suivant la revendication 2, caractérisé en ce que deux résistances ($R_c$, $R_d$) sont respectivement connectées à la source (S) et au caisson (B) dudit transistor ($T_P$').

**5.** Oscillateur suivant l'une quelconque des revendications 1 à 4, caractérisé en ce que lesdits moyens de limitation de courant comprennent une diode (Da).

**6.** Oscillateur suivant l'une quelconque des revendications 1 à 5, caractérisé en ce que lesdits moyens de limitation de courant (R1) sont communs à plusieurs transistors (M2, M4, M6) de même type de conductivité.

**7.** Oscillateur suivant la revendication 6, caractérisé en ce que lesdits moyens de limitation de courant (R1) sont reliés en série avec un condensateur (C4) entre les bornes d'alimentation ($V_{DD}$, $V_{SS}$) de l'oscillateur.

**8.** Oscillateur suivant l'une quelconque des revendications précédentes, caractérisé en ce qu'il comprend trois inverseurs (I1, I2 et I3) montés en cascade, rebouclés en anneau et formés chacun par une paire de transistors complémentaires (M1-M2, M3-M4, M5-M6).

**9.** Oscillateur suivant la revendication 8, caractérisé en ce que dans chaque paire de transistors complémentaires, la jonction source-caisson (S-B) du transistor de même type que le substrat est polarisée dans le sens direct.

**10.** Oscillateur suivant l'une quelconque des revendications 8 et 9, caractérisé en ce que le dernier (I3) desdits inverseurs est connecté à un montage de décalage de niveau (M7, R2) afin d'augmenter l'amplitude de sortie de l'oscillateur.

**11.** Oscillateur suivant l'une quelconque des revendications 8 à 10, caractérisé en ce qu'il comprend également un circuit d'attaque (M8, M9, M10) pour augmenter le courant à la sortie de l'oscillateur.

**12.** Oscillateur suivant la revendication 11, caractérisé en ce que ledit circuit d'attaque comprend une paire de transistors complémentaires (M8, M9) dont au moins l'un des transistors (M9) présente une jonction source-caisson (S-B) polarisée dans le sens direct.

**13.** Oscillateur suivant la revendication 12, caractérisé en ce qu'il comprend également un transistor de commutation (M10) pour rendre inopérante ladite polarisation directe des transistors du circuit d'attaque (M8, M9, M10) lorsque la tension d'alimentation sur lesdites bornes ($V_{DD}$, $V_{SS}$) dépasse une valeur prédéterminée.

## Fig. 1

D G S B $V_{DD}$

$T_N$

N+ N+ P+ N+

P

N

$D_p$

$Q_N$

A

## Fig. 2

D $V_{DD}$

G B

S

$R_a$

$V_{SS}$

$T_N$

## Fig. 3

D $V_{DD}$

$R_b$

G B

S

$V_{SS}$

$T_N$

## Fig. 4

D G S B $V_{SS}$ S G D

P+ P+ N+ P+ N+ N+

N

P

$D_p'$

$T_N'$

$T_P'$ $Q_p$

A

Fig. 5

Fig. 6

Fig. 7

Fig. 8

Fig. 9

Fig. 10

## Fig. 11

(a)

□ V(N1)  ◇ V(N2)  ▽ V(N3)

(b)  $V_{DD}=0,4\,V$

□ V(N4)  ◇ V($V_S$)  ▽ V(N5)

(c)

□ V(OUT)

Office européen
des brevets

**RAPPORT DE RECHERCHE EUROPEENNE**

Numero de la demande

EP 97 10 0261

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | IEEE TRANSACTIONS ON ELECTRON DEVICES, vol. 43, no. 6, Juin 1996, pages 904-909, XP000636245 CHEN M -J ET AL: "BACK-GATE FORWARD BIAS METHOD FOR LOW-VOLTAGE CMOS DIGITAL CIRCUITS" * page 904, colonne de gauche, alinéa 1 - page 905, colonne de droite, alinéa 1; figure 1 * | 1 | H03K3/00 H03K3/03 |
| A | EP 0 022 266 A (TOKYO SHIBAURA ELECTRIC CO) 14 Janvier 1981 * page 3, ligne 5-18 * | 1 | |
| A | US 3 855 549 A (HUENER R ET AL) 17 Décembre 1974 * figures 1-8 * | 1 | |
| A | US 5 017 811 A (WORLEY EUGENE R) 21 Mai 1991 * colonne 1, ligne 11-49 * | 1 | DOMAINES TECHNIQUES RECHERCHES (Int.Cl.6) |
| A | US 4 388 536 A (PEIL WILLIAM ET AL) 14 Juin 1983 * figures 1,2 * | 1 | H03K G04G |

Le présent rapport a été établi pour toutes les revendications

| Lieu de la recherche | Date d'achèvement de la recherche | Examinateur |
|---|---|---|
| LA HAYE | 13 Juin 1997 | Exelmans, U |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)